# EUROPEAN PATENT SPECIFICATION

(11) **EP 0 569 094 B1**
(45) Date of publication and mention of the grant of the patent: **21.08.1996**
(21) Application number: 93201261.0
(22) Date of filing: 04.05.1993
(51) Int. Cl.: H01L 21/445, H01L 33/00

(54) **Method of providing an ohmic contact on a ZnSe layer**
Verfahren zur Abscheidung eines ohmischen Kontaktes auf einer ZnSe-Schicht
Méthode de formation d'un contact ohmique sur une couche de ZnSe

(30) Priority: 05.05.1992 US 878657
(43) Date of publication of application: 10.11.1993
(73) Proprietor: Philips Electronics N.V., 5621 BA Eindhoven (NL)
(72) Inventor: Taskar, Nikhil, c/o INT. OCTROOIBUREAU B.V., NL-5656 AA Eindhoven (NL); Khan, Babar, c/o INT. OCTROOIBUREAU B.V., NL-5656 AA Eindhoven (NL)
(74) Representative: Rensen, Jan Geert

(56) References cited:
- US-A- 4 123 295
- JOURNAL OF THE ELECTROCHEMICAL SOCIETY vol. 114, no. 10, October 1967, MANCHESTER, NEW HAMPSHIRE US pages 1063 - 1066 AVEN ET AL. 'OHMIC ELECTRICAL CONTACTS TO P-TYPE ZnTe AND ZnSe(x)Te(1-x)'
- PATENT ABSTRACTS OF JAPAN vol. 14, no. 117 (E-898)5 March 1990
- PATENT ABSTRACTS OF JAPAN vol. 14, no. 348 (E-957)27 July 1990

## Description

The invention relates to a method of providing an ohmic contact on a ZnSe layer provided on a substrate by wetting the layer with a Hg containing liquid and heating the layer to a temperature in excess of 200°C.

Such a method is known from US-A-4 123 295 of McCaldin et al.. In this known method a contact is made on a ZnSe body doped with aluminium. The Hg containing liquid used was an amalgam of Hg, In and Cd. After wetting the body was heated to 450°C for 1 minute.

This known method may be used for providing an ohmic contact on an n-type, aluminium doped layer of ZnSe. The known method however can not be used for making ohmic contacts on p-type, nitrogen doped layers of ZnSe. Heating to a temperature of 450°C would destabilize the nitrogen dopants present in the layer, even for durations as short as 1 minute. The effective concentrations of the nitrogen dopants then would tend to decrease.

It is an object of the present invention to provide a method which can be used to make an ohmic contact on a p-type, nitrogen doped layer of ZnSe. Therefore, a method according to claim 1 is provided in order to obtain such an ohmic contact.

Surprisingly it has been found, that immersing the layer of ZnSe in the Hg containing bath significantly reduces the severity of the degradation mentioned above. Probably the immersing serves the purpose of an encapsulant. At temperatures above 200°C an alloying of Hg and the layer of ZnSe is initiated. After a time greater than 120 minutes a contact layer is formed on the layer and consists of HgₓZn₁₋ₓSe, in which x varying from 0 at the surface of the ZnSe layer to 1 at the outer surface of the contact layer. The layer grown forms an ohmic contact to the layer of ZnSe.

By way of example the invention further will be described with reference to a drawing. In the drawing
Fig. 1 is a cross-sectional view of a portion of a semiconductor structure comprising a heavily doped p-type zinc selenide layer provided with an ohmic contact of the invention;
Fig. 2 is an I-V plot of a p-type zinc selenide layer directly provided with a gold contact;
Figs. 3-9 are I-V plots of a p-type zinc selenide layer provided with the ohmic type contacts of the invention.

According an aspect of the invention the value of x at the outer surface of the ohmic type contact is 1. Thus, according to this aspect of the invention there is no zinc but mercury present at the outer surface of the ohmic type contact.

According to a still further preferred aspect of the invention an outer surface of the ohmic type contact is in contact with the conductive metallic layer. Examples of metals that may be used for such metallic layers are gold, silver, aluminium, tungsten and other metals used for the formation of conductive layers in the semiconductive art.

The ohmic type contact is a layer of HgₓZn₁₋ₓSe wherein x varies from 0 at the ZnSe layer to 1 at its outer surface.

The ohmic type contact may be doped or undoped, if the ohmic contact is doped it is preferably p doped. An example of a p dopant that may be employed is lithium.

The ohmic type contact is provided on the ZnSe layer preferably by immersing this layer in a bath of mercury heated to 200 to 350°C for a period of 2-24 hours. If doping is desired, Li may be added to the Hg bath.

Doping may also be achieved by heating the ohmic type contact to form Hg vacancies.

The conductive metallic layer may be provided by evaporation from a suitable metal upon removal of the ZnSe layer from the Hg bath.

The thickness of the layer forming the ohmic contact of the invention is about 100 Å to 3000 Å (10Å = 1nm) and preferably is about 1000 Å to 3000 Å (depending on the doping level in the p-type layer and the graded layer.)

### Example I

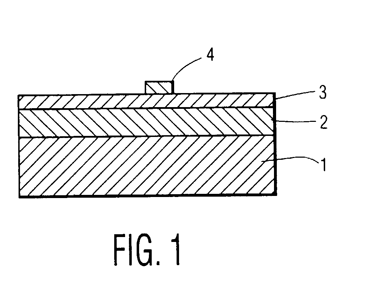

Referring to Fig 1, a semiconductor p-type gallium arsenide substrate 1 was provided with a p-type ZnSe layer 2 of a thickness of 1-2 µm. The p-type ZnSe layer and the p-type GaAs substrate form a rectifying heterojunction. The p-type ZnSe layer 2 was then immersed in a Hg bath heated to a temperature of 200°-350°C for a period of 2-24 hours.

As a result there was formed a thin layer 3 of a thickness of 100-200 Å HgₓZn₁₋ₓSe in which x=0-1 with x being 0 at the interface with the p-type ZnSe layer and 1 at its outer surface. An Au contact 4 of a thickness of about 1000 Å was then provided on the HgₓZn₁₋ₓSe layer by evaporation.

### Example II

The procedure as described in Example 1 was carried out with the addition in that an amount of Li to provide an Li doped concentration of 10¹⁶ - 10¹⁷ cm⁻³ in the resultant HgₓZn₁₋ₓSe layer was added to the Hg bath in the form of solid Li.

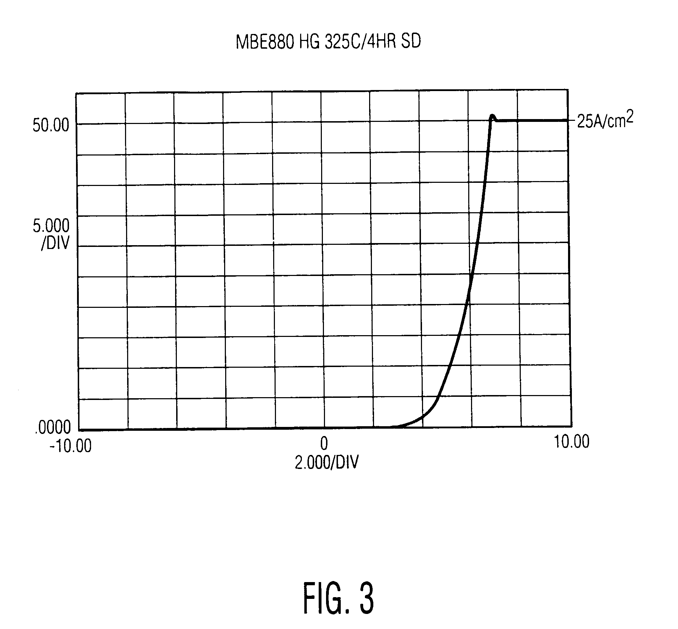

I-V plots measured on structures prepared according to these examples I and II are shown in Figures 3-9.

Fig. 3 shows the I-V plot measured on a structure with a layer which was undoped (i.e. without Li), whereby the alloying was carried out at a temperature of 325°C for a period of 4 hours. The size of the contact area of the gold contact was 2x10⁻³cm².

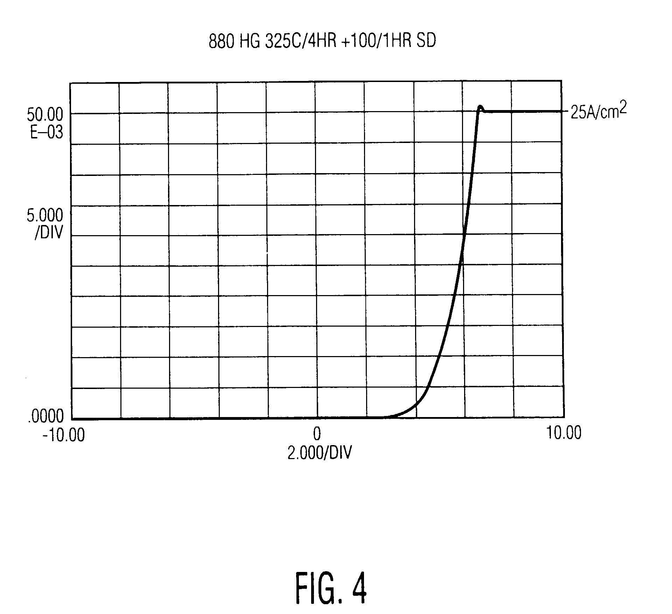

Fig. 4 shows the I-V plot measured on a structure with a layer which was heated at a temperature of 100°C for a period of 1 hour after the alloying (following removal from Hg bath) to form Hg vacancies. The contact area was 2.10⁻³ cm².

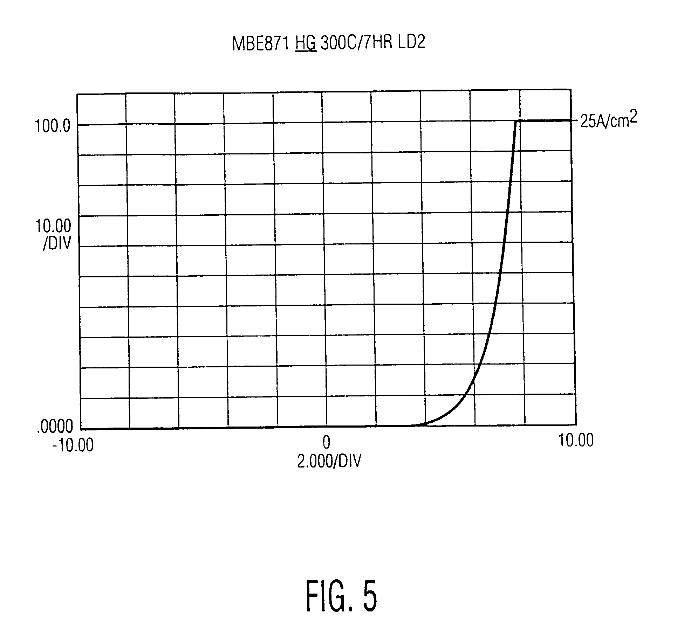

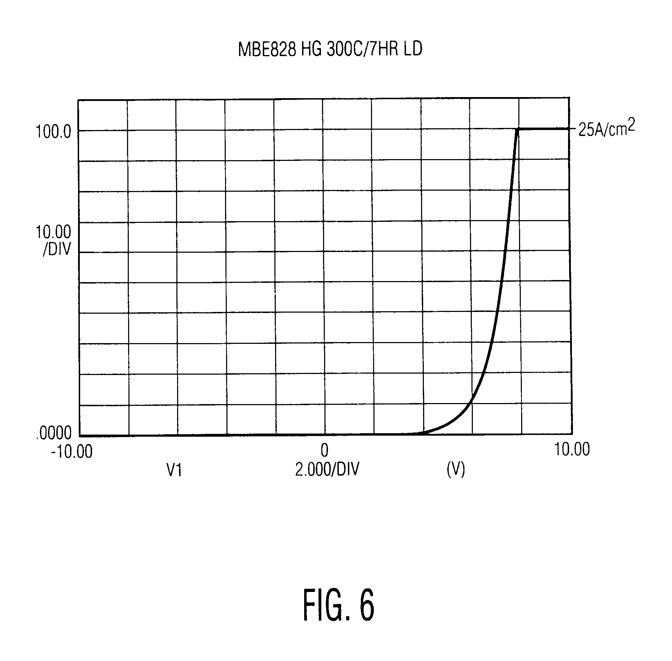

Fig. 5 as well as Fig. 6 shows the I-V plot measured on a structure with a layer of which the alloying was carried out at a temperature of 300° for a period of 7 hours. The size of the contact area of the gold contact was 4x10⁻³cm².

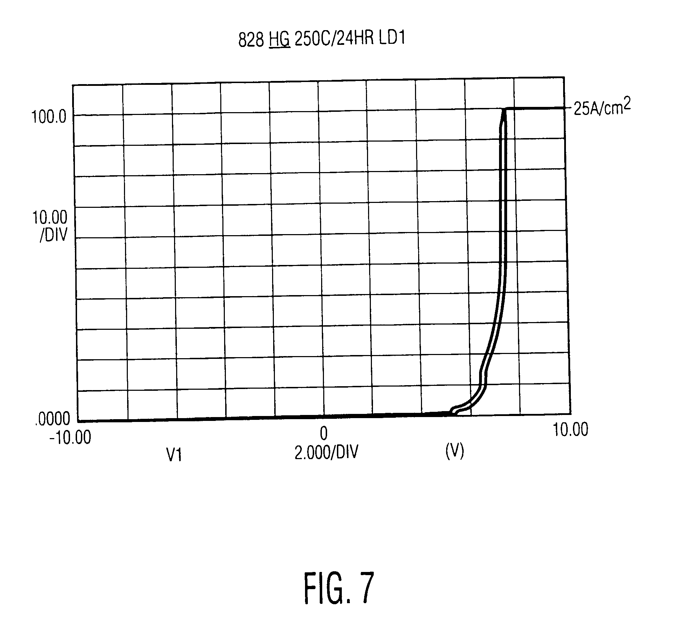

Fig. 7 shows the I-V plot measured on a structure with a layer of which the alloying was carried out at a temperature of 250°C for a period of 24 hours.

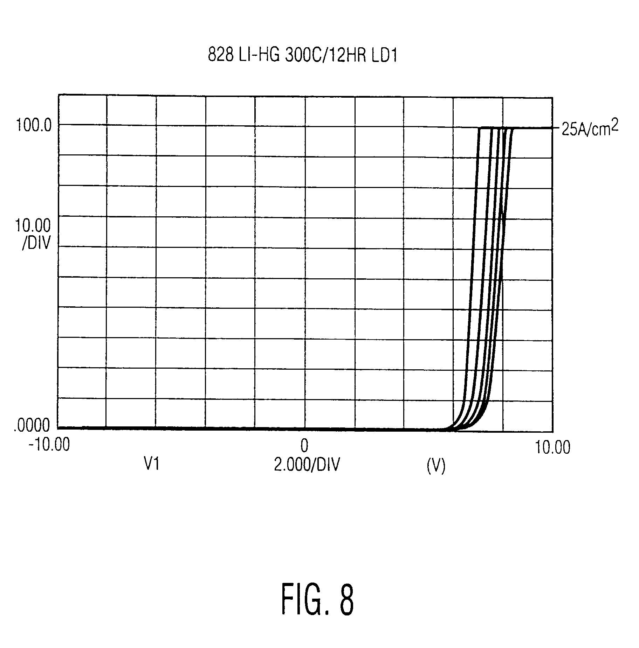

Fig. 8 shows the I-V plot measured on a structure with a layer which was doped with Li to a concentration of 10¹⁷,whereby alloying was carried out at a temperature of 300° for a period of 12 hours.

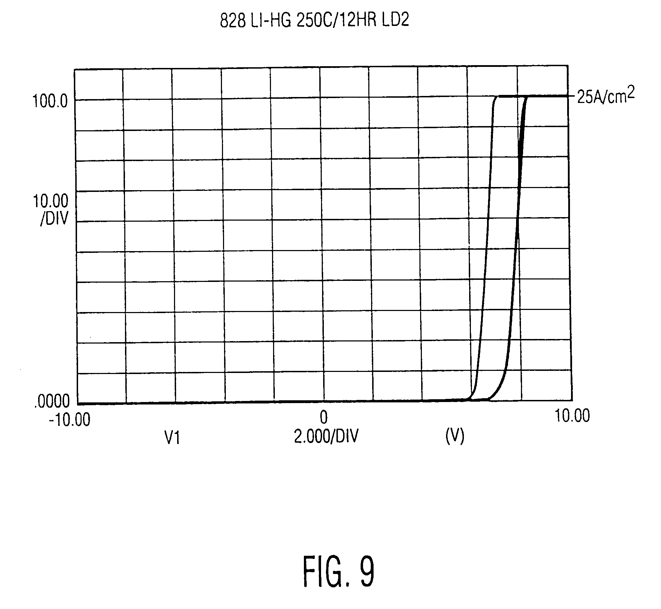

Fig. 9 shows the I-V plot measured on a structure with a layer of which the alloying was carried out at 250°C for a period of 12 hours.

In all these examples, the p-type ZnSe layers were nitrogen doped with a doping level of ∼ 10¹⁷.

Also shown in the plots is the current level corresponding to a current density of 25 A/cm². The current levels are 100 mA and 50 mA for "LD" and "SD", respectively. The thickness of the ZnSe layers were 1 µm. The ZnSe layer of figure 5 was 2 µm thick.

The plots shown are produced by a vertical application of voltage.

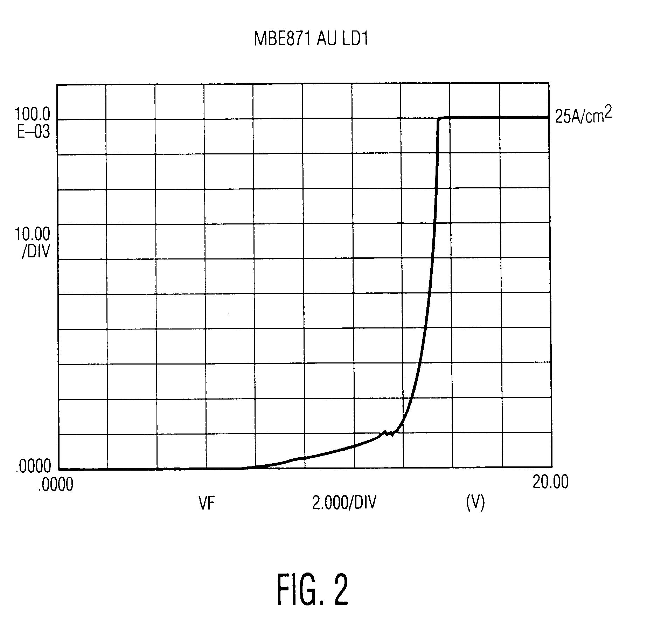

The plot shown in Fig. 2 was carried out in the same manner except that the Au contact was evaporated directly on the ZnSe layer.

As shown in the plots of Figures 3-9 a voltage level of 6.5-8V is required to obtain a current density level of the order of 25 A/cm² when the method of the invention is employed. However when the method of the invention is not employed, a voltage level of about 16V is required to obtain a current density level also of 25 A/cm² as shown in Fig. 2.

Thus the method of the invention clearly results in a significantly superior ohmic contact to the p-type ZnSe layer.

## Claims

1. Method of providing an ohmic contact layer on a p-type nitrogen doped ZnSe layer provided on a substrate , wherein said layer of ZnSe is wetted and heated by immersing said substrate with said p-type nitrogen doped ZnSe layer thereon in a Hg containing bath heated to a temperature in excess of 200°C but not greater than 350° C for a time greater than 120 minutes, whereby said ohmic contact layer is formed on said layer of ZnSe and consists of HgxZn1-xSe in which x varies from 0 at the surface of said ZnSe layer to 1 at the outer surface of said contact layer.

2. Method as claimed in Claim 1, characterized in that a doping amount of Li is included in said Hg containing bath.

3. Method as claimed in Claim 1 or 2, characterized in that the substrate is immersed in the heated Hg containing bath for a time less than 24 hours.

## Patentansprüche

1. Verfahren zum Verschaffen einer ohmschen Kontaktschicht auf einer auf einem Substrat vorhandenen p-stickstoffdotierten ZnSe-Schicht, wobei die genannte ZnSe-Schicht durchfeuchtet und erhitzt wird, indem das genannte Substrat mit darauf der genannten p-stickstoffdotierten ZnSe-Schicht länger als 120 Minuten in ein bis auf eine Temperatur über 200 °C, aber unter 350 °C erhitztes Hg-haltiges Bad getaucht wird, wodurch die genannte ohmsche Kontaktschicht auf der genannten ZnSe-Schicht gebildet wird und aus HgₓZn₁₋ₓSe besteht, wobei x zwischen 0 an der Oberfläche der genannten ZnSe-Schicht und 1 an der Außenfläche der genannten Kontaktschicht variiert.

2. Verfahren nach Anspruch 1, dadurch gekennzeichnet, daß eine Dotierungsmenge von Li in dem genannten Hg-haltigen Bad enthalten ist.

3. Verfahren nach Anspruch 1 oder 2, dadurch gekennzeichnet, daß das Substrat kürzer als 24 Stunden in das erhitzte Hg-haltige Bad getaucht wird.

## Revendications

1. Procédé pour former une couche de contact ohmique sur une couche de ZnSe dopée à l'azote de type p formée sur un substrat, dans lequel ladite couche de ZnSe est mouillée et chauffée par immersion du substrat portant la couche de ZnSe dopée à l'azote de type p dans un bain contenant du Hg chauffé à une température de plus de 200°C mais non supérieure à 350°C pendant une durée supérieure à 120 minutes de façon que la couche de contact ohmique se forme sur la couche de ZnSe et consiste en HgₓZn₁₋ₓSe où x varie de 0 à la surface de la couche de ZnSe à 1 à la surface extérieure de la couche de contact.

2. Procédé suivant la revendication 1, caractérisé en ce qu'une quantité dopante de Li est contenue dans le bain contenant du Hg.

3. Procédé suivant la revendication 1 ou 2, caractérisé en ce que le substrat est immergé pendant une durée inférieure à 24 heures dans le bain chauffé contenant du Hg.
